# EUROPÄISCHE PATENTSCHRIFT

(11) **EP 2 769 440 B1**
(45) Veröffentlichungstag und Bekanntmachung des Hinweises auf die Patenterteilung: **09.11.2016**
(21) Anmeldenummer: 12770067.2
(22) Anmeldetag: 26.09.2012
(51) Int. Cl.: H01R 13/52, H01R 13/504, H01R 13/432, H01R 12/72, H01R 9/03, H05K 5/00

(54) **STEUERGERÄT FÜR EIN KRAFTFAHRZEUG MIT EINEM STECKERGEHÄUSE**
CONTROL UNIT FOR A MOTOR VEHICLE HAVING A CONNECTOR HOUSING
APPAREIL DE COMMANDE POUR UN VÉHICULE AUTOMOBILE COMPORTANT UN BOÎTIER DE CONNECTEUR

(30) Priorität: 18.10.2011 DE 102011084727
(43) Veröffentlichungstag der Anmeldung: 27.08.2014
(73) Patentinhaber: Robert Bosch GmbH, 70442 Stuttgart (DE)
(72) Erfinder: WITTMANN, Rolf, 71638 Ludwigsburg (DE)
(86) Internationale Anmeldenummer: PCT/EP2012/068977
(87) Internationale Veröffentlichungsnummer: WO 2013/056956

(56) Entgegenhaltungen:
- EP-A1- 1 672 972
- JP-A- 2004 111 435
- US-A- 3 720 907
- US-A1- 2011 021 078

## Beschreibung

### Stand der Technik

In heutigen Kraftfahrzeugen wird eine Vielzahl von Steuergeräten verwendet. Derartige Steuergeräte dienen beispielsweise dazu, um der Verbrennungskraftmaschine eine vorbestimmte Kraftstoffmenge zuzuführen oder auch nur dazu, das Fenster oder das Schiebedach zu öffnen oder zu schließen. Trotz einer fortlaufenden Zentralisierung von Steuer- und Regelaufgaben in einige wenige in dem Kraftfahrzeug angeordnete Steuergeräte ist dennoch ein Teil an Steueraufgaben auf dezentral angeordnete Steuergeräte verteilt. In diesen dezentralen Steuergeräten werden zumeist einfache Steueraufgaben durchgeführt. Aufgrund der geringen Komplexität sind diese dezentralen Steuergeräte zumeist preiswert in der Herstellung. Um diese Steuergeräte mit den zugehörigen Leitungen zu verbinden, werden in der Regel die Ausgänge der Steuergeräte mit einem Steckverbinder und die zugehörigen Leitungen mit einem korrespondierenden Steckverbinder versehen, die dann vor Ort bei der Montage aneinander verbunden werden. Angesichts stetig fallender Preise bei der Herstellung derartiger dezentraler Steuergeräte stellt die Kontaktierung zunehmend einen Kostenfaktor dar.

Dokument EP-A-1672972 offenbart die Merkmale des Oberbegriffs des unabhängigen Anspruchs 1.

### Zusammenfassung der Erfindung

Es kann somit ein Bedürfnis bestehen, ein Steuergerät bereitzustellen, das preiswert mit zugehörigen Leitungen kontaktierbar ist.

Das Bedürfnis kann befriedigt werden durch den Gegenstand des unabhängigen Anspruchs 1. Vorteilhafte Ausgestaltungen ergeben sich durch die Gegenstände der abhängigen Ansprüche.

Gemäß der Erfindung wird ein Steuergerät für ein Kraftfahrzeug nach Anspruch 1 bereitgestellt. Das Steuergerät weist einen Schaltungsträger mit wenigstens einer Leiterbahn auf. Mittels der wenigstens einen Leiterbahn sind elektrische und/oder elektronische Bauelemente miteinander elektrisch leitfähig verbunden. Die wenigstens eine Leiterbahn weist einen elektrisch kontaktierbaren Teilbereich auf. Ein Steckergehäuse ist mit dem Schaltungsträger verbunden, wobei an dem Steckergehäuse wenigstens eine Kontaktelementaufnahmekammer zur Aufnahme wenigstens eines elektrischen Kontaktelements ausgebildet ist. Wenn ein an einem Ende einer Leitung angeschlagenes Kontaktelement in seine endgültige Position in der Kontaktelementaufnahmekammer verlagert ist, ist das Kontaktelement an den elektrisch kontaktierbaren Teilbereich elektrisch leitfähig verbunden.

Hierbei kann ein an einer Leitung angeschlagenes elektrisches Kontaktelement in ein Steckergehäuse eingeführt und gleichzeitig an einen Schaltungsträger kontaktiert werden. Das Kontaktelement wird direkt an die Leiterbahn mittels des mit dem Schaltungsträger verbundenen Steckergehäuses elektrisch verbunden.

Das Steuergerät kann somit direkt an den Leitungskonfektionär geliefert werden, der die Kontaktelemente anstatt in einen separate Steckverbinder, wie dies aus dem Stand der Technik bekannt ist, direkt in das Steckergehäuse des Steuergerätes montiert. Somit wird das Steuergerät bereits beim

Kabelkonfektionär in dem Kabelbaum eingebunden. Damit entfällt zumindest ein Fertigungsschritt und die damit verbundenen Kosten gegenüber dem Stand der Technik, bei dem die Kontaktelemente zuerst in einen Steckverbinder eingesetzt werden, um dann bei der Montage des Kraftfahrzeugs diesen Steckverbinder mit dem Steuergerät zu verbinden. Das Steckergehäuse kann direkt an dem Schaltungsträger angeordnet sein. Auch ist das Steckergehäuse an einem den Schaltungsträger umgebenden Gehäuse angeordnet. Das Steckergehäuse fixiert das Kontaktelement derart, dass eine Kontaktfläche des elektrischen Kontaktelements an den elektrisch kontaktierbaren Teilbereich der elektrischen Leiterbahn des Schaltungsträgers kontaktiert ist. Das Steckergehäuse kann am Rand des Schaltungsträgers oder in dessen Mitte angeordnet sein. Die elektrischen Leitungen mit den Kontaktelementen können waagerecht oder senkrecht oder in beliebiger Winkelstellung in das Steckergehäuse einführbar sein, wobei die elektrische Leitung insbesondere bei einer senkrechten Einführung in der Regel umgelenkt werden wird, damit das Kontaktelement an dem Teilbereich der Leiterbahn elektrisch leitfähig verbunden ist. Der Schaltungsträger selber kann starr oder flexibel ausgestaltet sein, zum Beispiel als PCB (Printed Circuit Board) oder als Flex-Leiterplatte beispielsweise auf Basis von Polyamidfolien. Insbesondere bei einer Ausführung als mehrlagige Leiterplatte wird der elektrisch kontaktierbare Teilbereich der Leiterbahn in der Regel an der Oberseite der Leiterplatte angeordnet sein, an der auch die elektrischen und/oder elektronischen Bauelemente angeordnet sind. Das Steckergehäuse kann ein- oder mehrpolig ausgeführt sein. Auch kann das Steckergehäuse elektrisch leitfähig, insbesondere wenn es einpolig ausgebildet ist, oder elektrisch isolierend ausgeführt sein. Insbesondere bei mehrpoligen Steckergehäusen kann das Steckergehäuse elektrisch leitfähig ausgestaltet sein, wohingegen die Kontaktelementaufnahmekammern elektrisch isolierend ausgestaltet sind. Die Kontaktelementaufnahmekammer kann an der Seite, die dem elektrisch kontaktierbaren Teilbereich der Leiterbahn zugewandt ist, zumindest teilweise offen gestaltet sein.

Gemäß einem weiteren Ausgestaltungsbeispiel der Erfindung ist der Schaltungsträger durch eine erste Seite und eine der ersten Seite gegenüberliegende und im Wesentlichen parallel zu dieser angeordnete zweite Seite sowie eine umlaufende Kante begrenzt. Der elektrisch kontaktierbare Teilbereich ist an der ersten und/oder zweiten Seite angeordnet und durch die umlaufende Kante begrenzt. Das Steckergehäuse umgibt den elektrisch kontaktierbaren Teilbereich derart, dass eine Verlagerung des Kontaktelements in seine endgültige Position an die Kontaktelementaufnahmekammer lediglich in einer vorbestimmten Richtung möglich ist. Die vorbestimmte Richtung ist im Wesentlichen senkrecht auf die Kante, im Wesentlichen parallel zu der ersten und/oder zweiten Seite und hin zu den elektrischen und/oder elektronischen Bauelementen gerichtet.

Der hier verwendete Ausdruck "im Wesentlichen" bezieht sich darauf, dass aufgrund der Fertigungstoleranzen Abweichungen von einem Idealmaß möglich sind. Das Steckergehäuse kann hierbei in einem Randbereich des Schaltungsträgers angeordnet sein. Somit können die Kontaktelemente in besonders einfacher Weise an den Schaltungsträger verbunden werden, nämlich, indem ein das Steuergerät umgebender Außenraum genutzt wird.

Gemäß einem weiteren Ausgestaltungsbeispiel der Erfindung weist das Steckergehäuse eine Ausformung auf, wobei die Ausformung vor der Kante des elektrisch kontaktierbaren Teilbereichs angeordnet ist. Die Ausformung ist derart ausgebildet, dass das Kontaktelement bei seinem Verlagern in die endgültige Position die Kante nicht berührt.

Hierbei kann die Ausformung beispielsweise stufenförmig ausgebildet sein, so dass bei der Montage des Kontaktelements dessen Kontaktfläche, die, wenn das Kontaktelement in seine endgültige Position verlagert ist, an der Leiterbahn anliegt, über die Kante hinweggeführt ist, ohne die Kante zu berühren. Dementsprechend wird in der Regel die Stufe der Ausformung gegenüber der benachbarten Seite des Schaltungsträgers überhöht ausgeführt sein. Wenn das Kontaktelement beim Verlagern in seine endgültige Position über die Kante des Schaltungsträgers geschoben werden müsste, könnte dies den Schaltungsträger und/oder das Kontaktelement schädigen. Auch trägt eine derartige Ausgestaltung des Steckergehäuses auch dazu bei, dass der Schaltungsträger zumindest im Bereich des elektrisch kontaktierbaren Teilbereichs durch das Steckergehäuse während des Transports zum Kabelkonfektionär vor Beschädigung geschützt ist. Für eine zuverlässige Kontaktierung des Kontaktelements an den Teilbereich der Leiterbahn kann die Kontaktfläche des Kontaktelements federnd vorgespannt sein. Hierbei kann die Kontaktfläche des Kontaktelements aus einem federnden und elektrisch leitfähigen Blech hergestellt ist, wobei das Blech zweidimensional oder dreidimensional verformt sein kann.

Gemäß der Erfindung ist der Schaltungsträger von einer Moldmasse umgeben. Wenn das Steckergehäuse an dem Schaltungsträger angeordnet ist, ist ein Eindringen von Moldmasse in den elektrisch kontaktierbaren Teilbereich verhindert.

Moldmasse beispielsweise auf Epoxidharzbasis ist, wenn sie vergossen wird, dünnflüssig. Um ein Eindringen der Moldmasse in den elektrisch kontaktierbaren Teilbereich zu verhindern, kann das Steckergehäuse an den Schaltungsträger beispielsweise geklebt sein. Auch kann das Steckergehäuse umlaufend über eine dünne Rippe verfügen, die, wenn das Steckergehäuse an dem Schaltungsträger angeordnet ist, mit dem Schaltungsträger eine Presspassung ausbildet und auf diese Weise ein Eindringen der flüssigen Moldmasse verhindert.

Gemäß einem weiteren Ausgestaltungsbeispiel der Erfindung ist zwischen dem Steckergehäuse und dem Schaltungsträger ein Dichtelement angeordnet.

Somit kann ein Eindringen der flüssigen Moldmasse durch das Dichtelement verhindert sein. Hierbei kann das Dichtelement als ein selbstständiges Bauteil ausgestaltet sein, das bei der Montage zwischen Schaltungsträger und Steckergehäuse eingebracht wird. Auch kann das Dichtelement in Verbindung mit dem Steckergehäuse derart gestaltet sein, dass das Dichtelement vor der Montage des Steckergehäuses an den Schaltungsträger an das Steckergehäuse unverlierbar verbindbar ist. Weiterhin kann das Dichtelement derart gestaltet sein, dass es an das Steckergehäuse angespritzt ist. Insbesondere ist dies möglich, wenn das Dichtelement aus einem Thermoplast gestaltet ist. Das Dichtelement kann im Querschnitt jede beliebige geometrische Form einnehmen. Bevorzugt kann es einen quadratischen, rechteckigen, runden oder auch elliptischen Querschnitt besitzen. Weiterhin kann das Dichtelement auch als Hohlkörper ausgebildet sein.

Gemäß der Erfindung ist der Schaltungsträger von einer Moldmasse umgeben. Das Steckergehäuse weist eine Außenseite auf. An der Außenseite ist wenigstens eine Ausformung derart ausgebildet, dass die Ausformung mit der ausgehärteten Moldmasse formschlüssig verbunden ist.

Durch das Eingießen des Steckergehäuses wird das Steckergehäuse unlösbar an dem Schaltungsträger fixiert. Durch die formschlüssige Verbindung können auch Werkstoffe für die Moldmasse und das Steckergehäuses verwendet werden, die miteinander keine kohäsive Verbindung eingehen würden. Die Ausformungen können gegenüber der Außenseite des Gehäuses als Vorsprünge oder Rücksprünge ausgebildet sein. In der Regel werden diese Ausformungen Hinterschnitte aufweisen, in die die unausgehärtete Moldmasse fließen kann, um die formschlüssige Verbindung herzustellen. In ausgehärtetem Zustand ist die Moldmasse fest. Insbesondere, wenn das Steckergehäuse als ein Spritzgussteil ausgeformt ist, können derartige Ausformungen auf einfache Weise in der Spritzgussform integriert sein.

Gemäß einem weiteren Ausgestaltungsbeispiel der Erfindung ist das Steckergehäuse gemeinsam mit der Kontaktelementaufnahmekammer einstückig aus elektrisch isolierendem Material ausgebildet.

Als elektrisch isolierendes Material wird hierbei in der Regel ein spritzfähiges Kunststoffmaterial verwendet, so dass das Steckergehäuse im Spritzgussverfahren herstellbar ist. Hierbei ist die Kontaktelementaufnahmekammer in das Steckergehäuse integriert. Das Steckergehäuse kann hierbei sowohl aus einem Thermoplast als auch einem Duroplast gestaltet sein. Durch die Gestaltung als Spritzgussteil ist das Steckergehäuse äußerst preiswert in großen Stückzahlen herstellbar.

Gemäß einem weiteren Ausgestaltungsbeispiel der Erfindung weist die wenigstens eine Kontaktelementaufnahmekammer des Steuergeräts wenigstens ein Verrastungselement auf, wobei das wenigstens eine Kontaktelement an dem Verrastungselement unlösbar verrastet ist, wenn das Kontaktelement in seine endgültige Position in der Kontaktelementaufnahmekammer verlagert ist.

Die unlösbare Verrastung des Kontaktelements an der

Kontaktelementaufnahmekammer kann bedeuten, dass das Kontaktelement nicht ungewollt aus der Kontaktelementaufnahmekammer verlagert werden kann, beispielsweise während des Betriebs durch Vibration. Natürlich kann das Kontaktelement derart gestaltet sein, dass durch Betätigen eines Entriegelungselements, das auch als separates Werkzeug ausgeführt sein kann, das Kontaktelement aus der Kontaktelementaufnahmekammer verlagert werden kann. Zur unlösbaren Verrastung kann beispielsweise das Kontaktelement eine Rastlanze besitzen, die in einen Hinterschnitt in der Kontaktelementaufnahmekammer greift.

Gemäß einem weiteren Ausgestaltungsbeispiel der Erfindung wird eine Anordnung bestehend aus einem Steuergerät gemäß obiger Beschreibung und einem Kabelbaum bereitgestellt. Der Kabelbaum weist wenigstens eine an das Steuergerät verbindbare Leitung mit einem an einem Ende angeschlagenen elektrischen Kontaktelement auf. Wenn das Kontaktelement in seine endgültige Position in einer Kontaktelementaufnahmekammer eines Steckergehäuses verlagert ist, ist das Kontaktelement an einem elektrisch kontaktierbaren Teilbereich einer Leiterbahn eines Schaltungsträgers elektrisch leitfähig verbunden.

Es wird angemerkt, dass Gedanken zu der Erfindung hierin im Zusammenhang sowohl mit einem Steuergerät als auch mit einer Anordnung bestehend aus einem Steuergerät und einem Kabelbaum beschrieben sind. Einem Fachmann ist hierbei klar, dass die einzelnen beschriebenen Merkmale auf verschiedene Weise miteinander kombiniert werden können, um so auch zu anderen Ausgestaltungen der Erfindung zu gelangen.

### Kurze Beschreibung der Zeichnungen

Ausführungsformen der Erfindung werden nachfolgend mit Bezug auf die beigefügten Figuren beschrieben. Die Figuren sind lediglich schematisch und nicht maßstabsgetreu.
- Fig. 1: zeigt ein Steuergerät mit einem an einem Schaltungsträger angeordneten, mittels einer Moldmasse in einer ersten Variante fixierten und mit Kontaktelementen bestückten Steckergehäuse im Querschnitt; und
- Fig. 2: zeigt das aus Fig. 1 bekannte Steuergerät mit dem an dem Schaltungsträger mittels der Moldmasse in einer zweiten Variante fixierten Steckergehäuse im Querschnitt.

### Detaillierte Beschreibung beispielhafter Ausführungsformen

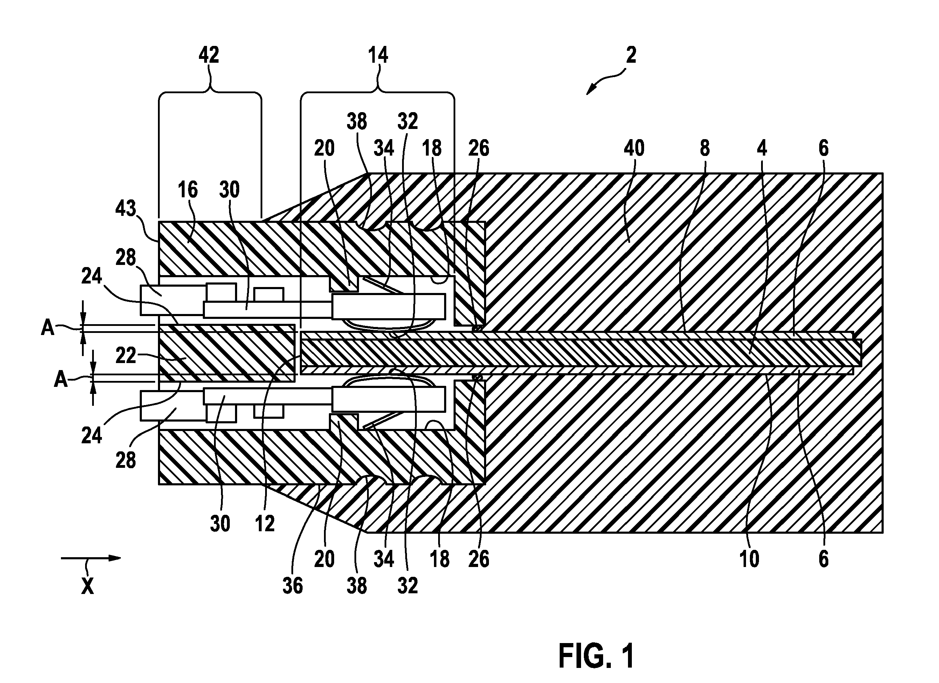

Fig. 1 zeigt ein Steuergerät 2 für ein Kraftfahrzeug mit einem als gedruckte Leiterplatte ausgebildeten Schaltungsträger 4. Der Schaltungsträger 4 ist begrenzt durch eine erste Seite 8, eine der ersten Seite 8 gegenüberliegende und im Wesentlichen parallel zu dieser angeordnete zweite Seite 10 sowie eine umlaufende Kante 12. Hierbei besitzen sowohl die erste Seite 8 als auch die zweite Seite 10 jeweils eine Leiterbahn 6. Mittels der Leiterbahn 6 sind hier nicht dargestellte elektrische und/oder elektronische Bauelemente verbunden, die auf dem Schaltungsträger 4 angeordnet sind. Die Leiterbahn 6 besitzt einen am Rand des Schaltungsträgers 4 angeordneten elektrisch kontaktierbaren Teilbereich 14, der ebenfalls durch die Kante 12 begrenzt ist. Der elektrisch kontaktierbare Teilbereich 14 ist mittels eines Steckergehäuses 16 umgeben. Das Steckergehäuse 16 besitzt in dem hier vorliegenden Ausführungsbeispiel zwei einander gegenüberliegende und spiegelbildlich zueinander ausgebildete Kontaktelementaufnahmekammern 18. Jede Kontaktelementaufnahmekammer 18 besitzt ein Verrastungselement 20. Zwischen den beiden Kontaktelementaufnahmekammern 18 ist eine Ausformung 22 angeordnet, die unlösbar an dem Steckergehäuse 16 verbunden ist. Die Ausformung 22 ist derart ausgebildet, dass sie zwei einander gegenüberliegende und gleichartig ausgebildete Stufenflächen 24 besitzt, wobei die Stufenflächen 24 im Wesentlichen parallel zu der ersten 8, respektive zweiten Seite 10 der Leiterbahn 6 angeordnet sind. Hierbei ist jede Stufenfläche 24 gegenüber der benachbarten ersten 8 bzw. zweiten Seite 10 überhöht ausgebildet. Somit bildet sich zwischen jeder Stufenfläche 24 und der benachbarten Seite 8, 10 jeweils ein Abstand A aus. Ferner besitzt das Steckergehäuse 16 ein umlaufendes Dichtelement 26, welches im Wesentlichen den elektrisch kontaktierbaren Teilbereich 14 von dem restlichen Schaltungsträger 4 fluiddicht trennt, respektive verhindert, dass flüssige bzw. nicht ausgehärtete Moldmasse 40 in den elektrisch kontaktierbaren Teilbereich 14 gelangen und damit dessen elektrische Kontaktierbarkeit verhindern kann. An einer Leitung 28 ist ein elektrisches Kontaktelement 30 mit einer Kontaktfläche 32 und einer Verrastungslanze 34 angeschlagen. Dies kann beispielsweise durch Krimpen der Leitung 28 an das Kontaktelement 30 erfolgen. Hier dargestellt ist das in seine endgültige Position verlagerte Kontaktelement 30. Hierbei ist die Kontaktfläche 32 der Leiterbahn 6 zugewandt. Weiterhin ist die Kontaktfläche 32 federnd ausgestaltet, so dass die Kontaktfläche 32 an den elektrisch kontaktierbaren Teilbereich 14 der Leiterbahn 6 zuverlässig kontaktiert ist, bzw. elektrisch leitfähig verbunden ist. Die Rastlanze 34 ist mit dem Verrastungselement 20 verrastet, so dass ein ungewolltes Entfernen des Kontaktelements 30 aus der Kontaktelementaufnahmekammer 18 nicht erfolgen kann. Das Steckergehäuse 16 umgibt den elektrisch kontaktierbaren Teilbereich 14 derart, dass eine Verlagerung des Kontaktelements 30 in seine endgültige Position an die Kontaktelementaufnahmekammer 18 lediglich in einer vorbestimmten Richtung X möglich ist. Hierbei ist die vorbestimmte Richtung X im Wesentlichen senkrecht auf die Kante 12, im Wesentlichen parallel zu der ersten 8 und/oder zweiten Seite 10 und hin zu den hier nicht dargestellten elektrischen und/oder elektronischen Bauelementen gerichtet. Wenn nun das Kontaktelement 30 in die Kontaktelementaufnahmekammer 18 eingeführt wird, führt die Stufenfläche 24 die Kontaktfläche 32 über die Kante 12 hinweg, so dass die Kontaktfläche 32 nicht mit der Kante 12 in Berührung kommt und damit weder der Schaltungsträger 4 noch das Kontaktelement 30 beschädigt werden kann. Weiterhin besitzt das Steckergehäuse 16 umlaufend an seiner Außenseite 36 als zwei zueinander parallele ellipsenförmige Vertiefungen ausgebildete Ausformungen 38. In dem hier dargestellten Ausführungsbeispiel sind die hier nicht dargestellten elektrischen und/oder elektronischen Bauelemente sowie das Steckergehäuse 16 bis auf einen vorbestimmten Bereich 42 an der Außenseite 36 mit Moldmasse 40 umgeben, wobei der Bereich 42 von einer Stirnseite 43 des Steckergehäuses 16 begrenzt ist. Die Moldmasse 40 schützt im ausgehärteten Zustand die elektrischen und/oder elektronischen Bauelemente sowie die Leiterbahnen 6 gegenüber einem das Steuergerät 2 umgebenden Medium, wie beispielsweise Spritzwasser. Ferner fixiert die Moldmasse 40 die elektrischen und/oder elektronischen Bauelemente derart auf dem Schaltungsträger 4, dass ihre Löt- und/oder Pressverbindungen mit den Leiterbahnen 6 aufgrund von Vibrationen nicht geschädigt werden können. Wenn nun der Schaltungsträger 4 mit den elektrischen und/oder elektronischen Bauelementen sowie dem an ihm angeordneten Steckergehäuse 16 mit der Moldmasse 40 umgeben wird, befindet sich die unausgehärtete Moldmasse 40 in einem flüssigen Zustand. Sowohl das Dichtelement 26 als auch ein den Bereich 42 an der Außenseite 36 des Steckergehäuses 16 abdeckendes und hier nicht dargestelltes Werkzeug verhindert ein Eindringen der flüssigen Moldmasse 40 in den elektrisch kontaktierbaren Teilbereich 14. Die ellipsenförmigen Ausformungen 38 werden hierbei von der Moldmasse 40 ausgefüllt bzw. umgeben, so dass in ausgehärtetem Zustand der Moldmasse 40 das Steckergehäuse 16 formschlüssig an die Moldmasse 40 verbunden ist. Die formschlüssige Verbindung erlaubt die Verwendung von Werkstoffen sowohl für die Moldmasse 40 als auch für das Steckergehäuse 16, die miteinander keine kohäsive Verbindung eingehen würden. Durch die formschlüssige Verbindung ist das Steckergehäuse 16 an der Moldmasse 40 unlösbar verbunden.

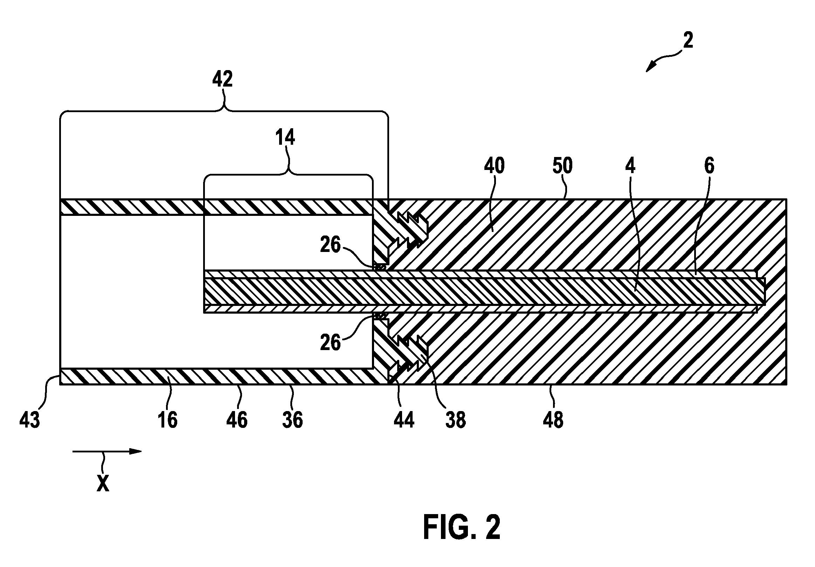

Fig. 2 zeigt das aus Fig. 1 bereits bekannte Steuergerät 2, wobei hier die Außenseite 36 des Steckergehäuses 16 sowie eine Außenkontur 50 der Moldmasse 40 gegenüber der Ausgestaltung in Fig. 1 geändert sind. Hierbei ist die Außenseite 36 des Steckergehäuses 16 sowie die Außenkontur 50 der Moldmasse 40 derart gestaltet, dass eine Oberseite 46 des Steckergehäuses 16 und eine Oberseite 48 der Moldmasse 40 zueinander bündig sind. Das Steckergehäuse 16 ist zur Moldmasse 40 hin durch eine Rückseite 44 begrenzt. An der Rückseite 44 sind an das Steckergehäuse 16 zwei übereinander angeordnete sägezahnförmig ausgebildete Ausformungen 38 angeordnet, die sich in die Moldmasse 40 hinein erstrecken. Auch hier wird durch die Ausformung 38 gewährleistet, dass das Steckergehäuse 16 mit der Moldmasse 40 formschlüssig verbunden ist. Somit wird das Steckergehäuse 16 an dem Schaltungsträger 4 durch die Moldmasse 40 unlösbar verbunden.

Es wird hier ein Steuergerät 2 bereitgestellt, bei dem das Kontaktelement 30 direkt an die Leiterbahn 6 mittels des mit dem Schaltungsträger 4 verbundenen Steckergehäuses 16 elektrisch verbindbar ist. Das Steuergerät 2 kann somit direkt an den Leitungskonfektionär geliefert werden, der die Kontaktelemente 30 anstatt in einen separaten Steckverbinder, wie dies aus dem Stand der Technik bekannt ist, direkt in das Steckergehäuse 16 des Steuergerätes 2 montiert. Somit wird das Steuergerät 2 bereits beim Kabelkonfektionär in dem Kabelbaum eingebunden. Damit entfällt zumindest ein Fertigungsschritt und der damit verbundenen Kosten gegenüber dem Stand der Technik, bei dem die Kontaktelemente 30 zuerst in einen Steckverbinder eingesetzt werden, um dann bei der Montage des Kraftfahrzeugs diesen Steckverbinder mit dem Steuergerät 2 zu verbinden.

## Patentansprüche

1. Steuergerät für ein Kraftfahrzeug, wobei das Steuergerät einen Schaltungsträger (4) mit wenigstens einer Leiterbahn (6) aufweist, wobei mittels der wenigstens einen Leiterbahn (6) elektrische und/oder elektronische Bauelemente miteinander elektrisch leitfähig verbunden sind, wobei die wenigstens eine Leiterbahn (6) einen elektrisch kontaktierbaren Teilbereich (14) aufweist,
wobei ein Steckergehäuse (16) mit dem Schaltungsträger (4) verbunden ist, wobei an dem Steckergehäuse (16) wenigstens eine Kontaktelementaufnahmekammer (18) zur Aufnahme wenigstens eines elektrischen Kontaktelements (30) ausgebildet ist, wobei, wenn ein an einem Ende einer Leitung (28) angeschlagenes Kontaktelement (30) in seine endgültige Position in der Kontaktelementaufnahmekammer (18) verlagert ist, das Kontaktelement (30) an den elektrisch kontaktierbaren Teilbereich (14) elektrisch leitfähig verbunden ist,
wobei eine Kontaktfläche (32) des elektrischen Kontaktelements (30) an den elektrisch kontaktierbaren Teilbereich (14) kontaktiert ist,
wobei der Schaltungsträger (4) von einer Moldmasse (40) umgeben ist, wobei das Steckergehäuse (16) eine Außenseite (36) aufweist, **dadurch gekennzeichnet, dass** an der Außenseite (36) des Steckergehäuses wenigstens eine Ausformung (38) derart ausgebildet ist, dass die Ausformung (38) mit der ausgehärteten Moldmasse (40) formschlüssig verbunden ist.

2. Steuergerät nach Anspruch 1,
**dadurch gekennzeichnet, dass**
der Schaltungsträger (4) durch eine erste Seite (8) und eine der ersten Seite (8) gegenüberliegende und im Wesentlichen parallel zu dieser angeordnete zweite Seite (10) sowie eine umlaufende Kante (12) begrenzt wobei der elektrisch kontaktierbare Teilbereich (14) an der ersten (8) und/oder zweiten Seite (10) angeordnet ist und durch die umlaufende Kante (12) begrenzt ist,
wobei das Steckergehäuse (16) den elektrisch kontaktierbaren Teilbereich (14) derart umgibt, dass eine Verlagerung des Kontaktelements (30) in seine endgültige Position in der Kontaktelementaufnahmekammer (18) lediglich in einer vorbestimmten Richtung (X) möglich ist, wobei die vorbestimmte Richtung (X) im Wesentlichen senkrecht auf die Kante (12), im Wesentlichen parallel zu der ersten (8) und/oder zweiten Seite (10) und hin zu den elektrischen und/oder elektronischen Bauelementen gerichtet ist.

3. Steuergerät nach Anspruch 2,
**dadurch gekennzeichnet, dass**
das Steckergehäuse (16) eine Ausformung (22) aufweist,
wobei die Ausformung (22) vor der Kante (12) des elektrisch kontaktierbaren Teilbereichs (14) angeordnet ist,
wobei die Ausformung (22) derart ausgebildet ist, dass das Kontaktelement (30) bei seinem Verlagern in die endgültige Position die Kante (12) nicht berührt.

4. Steuergerät nach einem der vorhergehenden Ansprüche,
**dadurch gekennzeichnet, dass** wenn das Steckergehäuse (16) an dem Schaltungsträger (4) angeordnet ist, ein Eindringen von Moldmasse (40) in den elektrisch kontaktierbaren Teilbereich (14) verhindert ist.

5. Steuergerät nach Anspruch 4,
**dadurch gekennzeichnet, dass**
zwischen dem Steckergehäuse (16) und dem Schaltungsträger (4) ein Dichtelement (26) angeordnet ist.

6. Steuergerät nach einem der vorhergehenden Ansprüche,
**dadurch gekennzeichnet, dass**
das Steckergehäuse (16) gemeinsam mit der Kontaktelementaufnahmekammer (18) einstückig aus elektrisch isolierendem Material ausgebildet ist.

7. Steuergerät nach einem der vorhergehenden Ansprüche,
**dadurch gekennzeichnet, dass**
die wenigstens eine Kontaktelementaufnahmekammer (18) wenigstens ein Verrastungselement (20) aufweist, wobei das wenigstens eine Kontaktelement (30) an dem Verrastungselement (20) unlösbar verrastet ist, wenn das Kontaktelement (30) in seine endgültige Position in der Kontaktelementaufnahmekammer (18) verlagert ist.

8. Anordnung bestehend aus einem Steuergerät nach einem der Ansprüche 1 bis 7 und einem Kabelbaum,
**dadurch gekennzeichnet, dass**
der Kabelbaum wenigstens eine an das Steuergerät (2) verbindbare Leitung (28) mit einem an einem Ende angeschlagenen elektrischen Kontaktelement (30) aufweist,
wobei das Kontaktelement (30), wenn das Kontaktelement (30) in seine endgültige Position in einer Kontaktelementaufnahmekammer (18) eines Steckergehäuses (16) verlagert ist, an einem elektrisch kontaktierbaren Teilbereich (14) einer Leiterbahn (6) eines Schaltungsträgers (4) elektrisch leitfähig verbunden ist.

## Claims

1. Control device for a motor vehicle, wherein the control device has a circuit carrier (4) comprising at least one conductor track (6), wherein electrical and/or electronic components are electrically conductively connected to one another by means of the at least one conductor track (6), wherein the at least one conductor track (6) has a subregion (14) with which electrical contact can be made, wherein a plug housing (16) is connected to the circuit carrier (4), wherein at least one contact element receiving chamber (18) for receiving at least one electrical contact element (30) is formed on the plug housing (16), wherein, when a contact element (30) which stops against one end of a line (28) is moved to its final position in the contact element receiving chamber (18), the contact element (30) is electrically conductively connected at the subregion (14) with which electrical contact can be made, wherein contact is made with a contact area (32) of the electrical contact element (30) at the subregion (14) with which electrical contact can be made, wherein the circuit carrier (4) is surrounded by a moulding compound (40), wherein the plug housing (16) has an outer side (36), **characterized in that** at least one moulding (38) is formed on the outer side (36) of the plug housing in such a way that the moulding (38) is connected to the cured moulding compound (40) in an interlocking manner.

2. Control device according to Claim 1, **characterized in that** the circuit carrier (4) is bounded by a first side (8), and a second side (10) which is situated opposite the first side (8) and is arranged substantially parallel to the said first side, and also a circumferential edge (12), wherein the subregion (14) with which electrical contact can be made is arranged on the first side (8) and/or second side (10) and is bounded by the circumferential edge (12), wherein the plug housing (16) surrounds the subregion (14) with which electrical contact can be made in such a way that movement of the contact element (30) to its final position in the contact element receiving chamber (18) is possible only in a predetermined direction (X), wherein the predetermined direction (X) is directed substantially perpendicular to the edge (12), substantially parallel to the first side (8) and/or second side (10) and in the direction of the electrical and/or electronic components.

3. Control device according to Claim 2, **characterized in that** the plug housing (16) has a moulding (22), wherein the moulding (22) is arranged in front of the edge (12) of the subregion (14) with which electrical contact can be made, wherein the moulding (22) is formed in such a way that the contact element (30) does not touch the edge (12) when it is moved into the final position.

4. Control device according to one of the preceding claims, **characterized in that**, when the plug housing (16) is arranged on the circuit carrier (4), ingress of moulding compound (40) into the subregion (14) with which electrical contact can be made is prevented.

5. Control device according to Claim 4, **characterized in that** a sealing element (26) is arranged between the plug housing (16) and the circuit carrier (4).

6. Control device according to one of the preceding claims, **characterized in that** the plug housing (16) is integrally formed from electrically insulating material together with the contact element receiving chamber (18).

7. Control device according to one of the preceding claims, **characterized in that** the at least one contact element receiving chamber (18) has at least one latching element (20), wherein the at least one contact element (30) can be latched to the latching element (20) in a captive manner when the contact element (30) is moved to its final position in the contact element receiving chamber (18).

8. Arrangement comprising a control device according to one of Claims 1 to 7 and a cable harness, **characterized in that** the cable harness has at least one line (28) which can be connected to the control device (2) and has an electrical contact element (30) which stops against an end, wherein the contact element (30), when the contact element (30) is moved to its final position in a contact element receiving chamber (18) of a plug housing (16), is electrically conductively connected at a subregion (14), with which electrical contact can be made, of a conductor track (6) of a circuit carrier (4).

## Revendications

1. Contrôleur pour un véhicule automobile, le contrôleur possédant au moins un porte-circuit (4) muni d'au moins une piste conductrice (6),
des composants électriques et/ou électroniques étant reliés entre eux de manière électriquement conductrice au moyen de l'au moins une piste conductrice (6),
l'au moins une piste conductrice (6) possédant une zone partielle (14) avec laquelle peut être établi un contact électrique,
un boîtier de fiche (16) étant relié au porte-circuit (4),
au moins une chambre d'accueil d'élément de contact (18) destinée à accueillir au moins un élément de contact (30) électrique étant configurée sur le boîtier de fiche (16),
un élément de contact (30) étant relié de manière électriquement conductrice à la zone partielle (14) avec laquelle peut être établi un contact électrique lorsque l'élément de contact (30) accroché à une extrémité d'une ligne (28) est déplacé dans sa position finale dans la chambre d'accueil d'élément de contact (18),
une surface de contact (32) de l'élément de contact (30) électrique étant en contact contre la zone partielle (14) avec laquelle peut être établi un contact électrique,
le porte-circuit (4) étant entouré d'une matière de moulage (40),
le boîtier de fiche (16) possédant un côté extérieur (36),
**caractérisé en ce qu'**au moins un façonnage (38) est configuré sur le côté extérieur (36) du boîtier de fiche de telle sorte que le façonnage (38) est relié à la matière de moulage (40) durcie par complémentarité de formes.

2. Contrôleur selon la revendication 1, **caractérisé en ce que** le porte-circuit (4) est délimité par un premier côté (8) et un deuxième côté (10) opposé au premier côté (8) et disposé sensiblement en parallèle à celui-ci ainsi que par une arête périphérique (12),
la zone partielle (14) avec laquelle peut être établi un contact électrique étant disposée sur le premier (8) et/ou le deuxième côté (10) et étant délimitée par l'arête périphérique (12),
le boîtier de fiche (16) entourant la zone partielle (14) avec laquelle peut être établi un contact électrique de telle sorte qu'un déplacement de l'élément de contact (30) dans sa position finale dans la chambre d'accueil d'élément de contact (18) est uniquement possible dans une direction (X) prédéfinie, la direction (X) prédéfinie étant sensiblement orientée perpendiculairement à l'arête (12), sensiblement parallèlement au premier (8) et/ou au deuxième côté (10) et en direction des composants électriques et/ou électroniques.

3. Contrôleur selon la revendication 2, **caractérisé en ce que**
le boîtier de fiche (16) possède un façonnage (22),
le façonnage (22) étant disposé devant l'arête (12) de la zone partielle (14) avec laquelle peut être établi un contact électrique,
le façonnage (22) étant configuré de telle sorte que l'élément de contact (30) ne touche pas l'arête (12) lors de son déplacement dans la position finale.

4. Contrôleur selon l'une des revendications précédentes, **caractérisé en ce que** lorsque le boîtier de fiche (16) est disposé sur le porte-circuit (4), la pénétration de la matière de moulage (40) dans la zone partielle (14) avec laquelle peut être établi un contact électrique est empêchée.

5. Contrôleur selon la revendication 4, **caractérisé en ce qu'**un élément d'étanchéité (26) est disposé entre le boîtier de fiche (16) et le porte-circuit (4).

6. Contrôleur selon l'une des revendications précédentes, **caractérisé en ce que** le boîtier de fiche (16) est réalisé d'une seule pièce en commun avec la chambre d'accueil d'élément de contact (18) en un matériau électriquement isolant.

7. Contrôleur selon l'une des revendications précédentes, **caractérisé en ce que** l'au moins une chambre d'accueil d'élément de contact (18) possède au moins un élément d'enclipsage (20), l'au moins un élément de contact (30) étant enclipsé de manière inamovible à l'élément d'enclipsage (20) lorsque l'élément de contact (30) est déplacé dans sa position finale dans la chambre d'accueil d'élément de contact (18).

8. Arrangement composé d'un contrôleur selon l'une des revendications 1 à 7 et d'un faisceau de câbles, **caractérisé en ce que** le faisceau de câbles possède au moins une ligne (28) pouvant être reliée au contrôleur (2) par un élément de contact (30) électrique accroché à une extrémité, l'élément de contact (30) étant relié de manière électriquement conductrice à la zone partielle (14) avec laquelle peut être établi un contact électrique d'une piste conductrice (6) d'un porte-circuit (4) lorsque l'élément de contact (30) est déplacé dans sa position finale dans une chambre d'accueil d'élément de contact (18) d'un boîtier de fiche (16).
